(19) Europäisches Patentamt
European Patent Office
Office européen des brevets

(11) Publication number: **0 243 159**
**A2**

(12) # EUROPEAN PATENT APPLICATION

(21) Application number: **87303517.4**

(22) Date of filing: **22.04.87**

(51) Int. Cl.4: **G 03 F 3/10**
G 03 C 1/68, G 03 F 7/10

(30) Priority: **22.04.86 US 854850 22.04.86 US 854851**
**22.04.86 US 854852**

(43) Date of publication of application:
**28.10.87 Bulletin 87/44**

(84) Designated Contracting States: **BE DE FR GB IT**

(71) Applicant: **MINNESOTA MINING AND MANUFACTURING COMPANY**
**3M Center, P.O. Box 33427**
**St. Paul, Minnesota 55133-3427 (US)**

(72) Inventor: **Sanders, James F. c/o Minnesota Mining and Manufacturing Company 2501 Hudson Road**
**P.O. Box 33427 St. Paul Minnesota 55133 (US)**

**Olson, David B. c/o Minnesota Mining and Manufacturing Company 2501 Hudson Road**
**P.O. Box 33427 St. Paul Minnesota 55133 (US)**

(74) Representative: **Bowman, Paul Alan et al**
**LLOYD WISE, TREGEAR & CO. Norman House 105-109 Strand**
**London WC2R OAE (GB)**

(54) **Photopolymerizable compositions.**

(57) Photopolymerizable compositions containing thermally-softenable, developer resistive polymeric binders are particularly useful in image transfer systems and processes.

**EP 0 243 159 A2**

**Description**

# PHOTOPOLYMERIZABLE COMPOSITIONS

## BACKGROUND OF THE INVENTION

### Field of the Invention

This invention relates to photopolymerizable compositions and particularly to negative-acting, photopolymerizable compositions useful in color prepress proofing constructions using a single receptor sheet to receive multiple color images on a single surface.

### Background of the Art

Photopolymerizable compositions are used in numerous commercial applications. Negative-acting photopolymerizable compositions are used in presensitized printing plates (e.g., U.S. Patents 3,218,167 and 3,887,450), prepress color proofing systems (e.g., U.S. Patents 3,136,637; 3,671,236; and 4,482,625), and as resist films for etching and plating of substrates (e.g., U.S. Patent 3,526,504).

Early photopolymerizable systems tended to have fairly slow photographic speeds and required long exposure under intense radiation to fully cure. This low speed was a function of low reactivity and few reactive groups in the monomers, poor radiation absorption and low efficiency in photoinitiators, and oxygen sensitivity in the acrylate functional polymerizable systems of choice. The speed of photopolymer compositions has been greatly increased by the use of monomers and coreactive oligomers with large numbers of reactive groups thereon (e.g., U.S. Patents 3,827,956; 4,065,627; 4,153,778; 4,228,232; and 4,304,923), higher efficiency photoinitiators (e.g., U.S. Patents 3,775,113; 3,729,313; 3,887,450; and 4,058,401), and the use of oxygen barrier topcoats such as poly(vinyl alcohol) and copolymers of acrylic acid (e.g., U.S. Patent 3,895,949).

U.S. Patent 4,228,232 shows a photopolymerizable composition which is particularly good, having both good photographic speed and oxygen insensitivity, without the use of polymeric barrier coatings on its surface. The composition comprises from 10 to 60% by weight of a polyfunctional photopolymerizable oligomer, 10 to 60% by weight of a photopolymerizable monomer, 10 to 60% by weight of a binder and 0.1 to 20.0 parts by weight of a photoinitiator system comprising a photoinitiator and sensitizing dye. This composition works quite well as a printing plate photosensitive composition. However, when used in a surprint color proofing system, there is very poor adhesive transfer of the image onto the receptor surface. The use of numerous types of binders is suggested.

## BRIEF DESCRIPTION OF THE INVENTION

Photopolymerizable compositions are described which are capable of being laminated after polymerization. The compositions are particularly useful in surprint processes where color prepress proofing images are transferred onto a receptor surface.

The compositions comprise 10-60% by weight of polyfunctional monomers, 10-60% by weight of polyfunctional reactive polymer, 10-60% by weight of an inert polymer which is not polymerizable in the polymerization process of the monomers and oligomers, and 0.1 to 20% by weight of a photoinitiator system. Additionally, the coatings may contain from 2 to 50% by weight of color dyes or pigments to provide a color proofing image.

Preferred imaging systems of the present invention contain a continuous photosensitive layer of between 0.1 and 20 microns and are characterized by containing 0.025 to 10% by volume of particles which are at least 1.5 times the thickness of the photosensitive layer and no greater than 40 or 80 microns.

## DETAILED DESCRIPTION OF THE INVENTION

At least four distinct classes of materials are needed to practice the present invention. Those four classes include (1) a polyfunctional monomer, (2) a polyfunctional reactive polymer, (3) an inert, thermoplastic polymeric binder, and (4) a photoinitiator system for the monomer and polymer. The term polyfunctional, as used in the practice of the present invention to describe both the monomer and oligomer requires that there be at least two functional groups on the material which are capable of polymerizing when activated by the photoinitiator system. Preferably each polyfunctional material will have at least three polymerizable groups thereon so that extensive cross-linking can occur. It is not essential that the functional groups of the monomer and oligomer be copolymerizable, but it is highly preferred that they are copolymerizable.

The proofing elements of the present invention may preferably comprise a support or carrier sheet and at least one photosensitive layer on said support. The photosensitive layer may be positive- or negative-acting, is between 0.1 to 20 microns thick, and contains 0.025 to 5 or 10% by volume of particles which are at least 1.5 times the thickness of the photosensitive layer and are no greater than 40 microns in their average diameter. Preferably the layer is between 0.2 and 10 microns thick, more preferably between 0.5 and 5 microns in thickness. The particles are preferably present between 0.05 and 2.5% by volume, more preferably as between 0.1 and 1 or 1.5% by volume. The particles are preferably at least twice (2 times) the thickness of the photosensitive layer (excluding the minor volume and thickness increase in the layer due to the presence of the particles) and more preferably at least thrice (3 times) the thickness of the photosensitive layer. Particles

having average diameters thirty times the thickness of the photosensitive layer have been used successfully. It is preferred that the particles be no more than 40 itmes the thickness of the photosensitive layer, more preferable than they be no more than thirty times the thickness of the layer. Generally the particles are preferred to have an average diameter of less than or equal to 40 microns and more preferred that they have an average diameter of less than 30 microns.

Monomers

The monomeric component of the present invention comprises a free radical polymerizable compound having at least two ethylenically unsaturated groups, and preferably at least 2 to 4 ethylenically unsaturated groups selected from the groups consisting of acrylate, methylacrylate, vinyl and allyl. Preferred are compounds having multiple acrylate and methacrylate groups, e.g., acrylic esters of low molecular weight polyols, such as trimethylolpropanetriacrylate, pentaerythritol tetraacrylate and triacrylate, etc. Preferably these monomers have a molecular weight of less than 2,000 and more preferably less than 1,000.

Suitable free radical polymerizable monomers useful in the compositions of the invention are well known and listed in many patents, e.g., U.S. Patent Nos. 3,895,949 and 4,037,021. Preferred monomers are the polyacrylate and polymethacrylate esters of alkanepolyols, e.g., pentaerythritol tetraacrylate, tris(2-acryloxyethyl)isocyanurate, tris(2-methyacryloxyethyl)isocyanurate, 2-acetoxyethyl methacrylate, tetrahydrofurfurylmethacrylate, 1-aza-5-acryloxymethyl-3, 7-dioxabicyclo [3.0.0] octane (ADOZ) bis[4-(2-acryloxyethyl-phenyl]dimethyl methane, diacetone acrylamide, and acrylamidoethyl methacrylate.

Initiator

The compositions of the present invention must also have a radiation sensitive system capable of initiating free radical polymerization upon absorption of radiation. Free radical initiators are materials known in the art, such as Free-Radical Chemistry, D. C. Nonhebel and J. C. Walton, University Press (1974). Particularly suitable free radical generators can be selected from many classes of organic compounds including, for example, organic peroxides, azo compounds, aromatic diazonium salts, aromatic iodonium salts, aromatic sulfonium salts, aromatic phosphonium salts, quinones, benzophenones, nitroso compounds, acyl halides, aryl halides, hydrazones, mercapto compounds, pyrylium compounds, triarylimidazoles, biimidazoles, chloroalkyltriazines, etc. These materials, in general, must have photosensitizers therewith to form a photoinitiator system. Photosensitizers are well known in the art. Of particular interest are aminoarylketone dyes, especially tertiaryaminoarylketones, and most particularly carboxylic acid substituted-tertiary-aminoarylketone dyes.

Additional reference in the art to free radical photoinitiator systems for ethylenically unsaturated compounds are included in U.S. Patent No. 3,887,450 (e.g., column 4), U.S. Patent No. 3,895, 949 (e.g. column 7), and U.S. Patent No. 4,043,819. Preferred initiators are the onium salts as disclosed in U.S. Patent Nos. 3,729,313; and the free radical initiator counterparts of U.S. 4,058,400; and 4,058,401. Other desirable initiators are biimidazoles (disclosed in U.S. patent application Serial No. 824,733, filed August 15, 1977) and chloroalkyltriazines as disclosed in U.S. Patent No. 3,775,113. These references also disclose sensitizers therein. Another good reference to photoinitiator system is Light-Sensitive Systems, J. Kosar, 1965, J. Wiley and Sons, Inc., especially Chapter 5.

Reactive Polymer

A reactive polymer is defined in the practice of the present invention as any polymeric material having at least two polymerizable groups thereon and having a molecular weight greater than that of the monomer component. Preferably the molecular weight of the reactive polymer is sufficiently high that it is a film-forming polymer by itself. This is generally indicated by a molecular weight of at least 2,000. It is also desirable that the reactive polymer swell in aqueous alkaline developer having a pH of 7.5 or greater. Combinations of reactive polymers are particularly desirable in tailoring the properties of the photosensitive layer. Swellability of one component emphasizes ease of developability in aqueous alkaline solution. Non-swellability of another reactive polymer component will contribute to the cohesiveness of the photosensitive layer during development. By balancing the properties of swellable and non-swellable reactive polymer, one can provide whatever balance of ease of developability and cohesive strength that is necessary for particular product needs.

The preferred reactive polymer component of the present invention comprises a free radical polymerizable polymer or oligomer having an ethylenically unsaturated group equivalent weight of between 45 and 5000 and being of a higher molecular weight than said monomer. Some preferred oligomers are shown in U.S. Patent No. 4,304,923 as urethane oligomers.

A generic structural formula for the urethane oligomers of that patent can be drawn as follows:

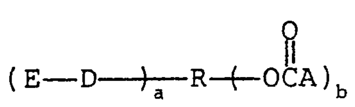

wherein

E is an ethylenically unsaturated, free radical polymerizable group, preferably selected from acryloyloxyalkoxy

(alternatively named acryloxyalkoxy), methacryloylalkoxy (alternatively named methacryloxyalkoxy), vinylalkoxy, and allyloxy,
D is the residue of a polyisocyanate (preferably a diisocyanate) having at least two of its -N=C=O groups reacted to form $-NH\underset{\underset{O}{\|}}{C}-$groups
D bonding E to R,
A is a carboxylic acid containing group (e.g.,

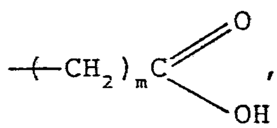 , $-C_6H_4\overset{\overset{O}{\|}}{C}OH$, etc.),

a is a number having an average value between 2 and 20,
b is a number having an average value between 0.3 and 10, and
m = 1 to 6,
R is the residue of a polyol having at least a+b hydroxyl groups and a number of average molecular weight between 90 and 10,000, the residue formed by removal of hydrogen from the hydroxyl groups.

The backbone of the oligomer, group R, may be any aromatic or aliphatic polyol having a molecular weight between 90 and 10,000. The backbone of the oligomer may be any oligomer with the requisite molecular weight and number of hydroxyl groups, but polyesterpolyols and polyoxyalkylene polyols are preferred. Linear oligomeric polyols are useful but the branched or three-dimensional polyols such as polycaprolactone polyols are preferred. The backbone may be prepared by any of the many well known methods of forming polyhydroxyl substituted oligomers having a molecular weight between 90 and 10,000. The polyols must have a hydroxy equivalent weight of between 45 and 5,000 to be useful according to the present invention. Preferably the polyol has a hydroxy equivalent weight between 90 and 4,000 and most preferably between 200 and 2,000.

The oligomer's backbone may be homopolymeric, copolymeric, graft polymeric, or mixtures thereof. For example, polycaprolactone polyols may be used, or lower molecular weight polycaprolactone polyols (average molecular weights of less than, for example, 500) may be joined by polyacids (preferably dicarboxylic acids) or by polyisocyanates (preferably diisocyanates) to form higher molecular weight oligomer backbones.

Other useful reactive polymers include the reaction of a styrene-maleic anhydride copolymer and hydroxyethylmethacrylate. That reaction is effected by simply heating the two materials in a non-reactive solvent. An example of a particularly useful class of non-swellable reactive binders is acrylate functional cellulose esters. A preferred example of that class is the reaction product of cellulose acetate proprionate and isocyanatoethylmethacrylate.

Adhesion Promoting Resin

The adhesion promoting resin component of the present invention comprises an organic, polymeric thermoplastic adhesion promoting resin having a molecular weight of at least 1,000 which is not reactive with the polymerization mechanism of the monomer or reactive polymer. It is important that the binding resin have a glass transition temperature (Tg) or softening point between 100°F (38°C) and 400°F (205°C) and that the resin in bulk form at a temperature between 150°F (63°C) and 400°F (205°C) has a viscosity of less than $10^3$ poise (preferably at 400°F the bulk material has a viscosity of less than or equal to $10^3$ poise). It is also further preferred that there is no plateau in the viscosity between 100°F and 400°F. These extended plateaus (at a change of temperatures of at least 15°C) indicate molecular entanglement which retards the flow properties of the binder resin and makes is less useful as a binding material. To be non-reactive with the reactive polymer and monomer, the resin must be able to pass the following test: 5 grams of the candidate resin, 3 grams of pentaerythritol tetraacrylate, 0.4 grams of diphenyliodonium hexafluoroantimonate and 0.4 grams of 4,4′-bis(dimethylamino) benzophenone sensitizing dye are dissolved in organic solvents (e.g., methylethylketone, isopropanol, ethylacetate, n-propanol/water azotrope, and mixtures thereof), and then irradiated for 15 seconds to a carbon arc having a 5,000 watt output at a distance of about 1 meter. If at least 90% by weight of the resin can be separated from the polymerized acrylate by leaching or other differential solvent techniques, the resin is non-reactive according to the teachings of the present invention.

Of the many different classes of resins disclosed in U.S. Patent 4,228,232, only two classes are potentially non-reactive according to the present invention and do not include the preferred class of polyketone resins. The patent teaches polyesters and polyacrylates generically, but does not teach the need for thermoplastic properties to be exhibited after polymerization and yet provide ease of clean developability. Furthermore, the generic classes of resins described do not necessarily have the properties needed for the present inventions. For example, the most common linear saturated polyesters (e.g. film base quality polyethyleneterephthalate) would not be useful in the present invention. The preferred resins of the present invention are polyketones, particularly polyketones having a molecular weight between 1,000 and 50,000. Preferably polyketones with a molecular weight between 1,000 and 10,000 are used.

The resins should be heat-softenable between 100 and 400°F (38°C to 205°C). It is also particularly useful to the present invention that the resin not be soluble in at least one solution selected from the class consisting of

aqueous alkaline solutions at a pH of 9.0 (e.g., water and NaOH), aqueous alcohol solutions (e.g., water and n-propanol, 80/20 blend), and organic solutions (e.g., toluene/ethyl acetate, 50/50 blend). The inability of the resin to be solubilized by at least one of these solutions assists in preserving desired properties during the development process. If the resin is not solubilizing and leached from the polymerized areas, its desirable thermoplastic properties will be preserved in the polymerized image areas, enable subsequent transfer.

Particles

The particles should preferably not add any significant color to the photosensitive layer other than that intended in its performance in a proofing sheet. For example, if the layer is to be the black proofing layer, the particles may be black, colorless (e.g., transparent) or, because of the small volume of particles, substantially any other color, even white. A color in such volume that would change the visual tone of the intended color of the layer would not be desirable. Therefore, even in a black layer, large amounts of a coloration in the particles which could change the hue of the black would be undesirable. Color sensitivity of the sheet to the particles is more important where the proof is to be used for the cyan, magenta or yellow layers in a proofing set. There the particles must have the same or similar color as the overall color of the proof or should white or colorless, although they may be transparent, opaque or translucent. Preferred particles are glasses and ceramics (e.g., silica, titania, zirconia, etc.) and polymeric particles (e.g., polymethylmethacrylate, polyacrylate, polyethylene etc.). The particles may have colorant therein or on their surfaces (as in cosmetic lakes) as long as those colors are compatible with the intended color of the layer. This essentially neutral effect on coloration of the sheet by the particles is referred to as color neutrality. That is, to be color neutral, the particles should not significantly alter the color balance of the layer from the color that is intended to be present in the layer.

The presence of the particles in the surface layer of the photosensitive element provides a surface morphology which enables the element to be easily moved over the surface of the receptor sheet to facilitate registration, enables the receptor sheet and photosensitive element (whether unexposed, exposed/undeveloped, or exposed/developed) to be drawn down (i.e., secured in non-adhesive contact by the application of a vacuum between the sheets), and prevents the entrapment of significant amounts of air between the element and the receptor. The morphology of the surface of the element also can facilitate a strong mechanical bond between the image and the receptor layer.

One important effect of the particles in the surface of the image transferred to the receptor sheet is to provide means for removing air between the image and the receptor sheet. The particles protrude sufficiently far from the surface to enable air to be pressed (as by a squeegee or rollers) or evacuated (by vacuum drawing) prior to adhesive securement of the image to the receptor. This removal of air is done prior to the thermal softening of the adhesive and the securement of the image to the receptor sheet. At least some of the air can also be removed prior to removal of substantially all of the air. This partial removal can be used to hold the image sheet and the receptor sheet in register prior to thermal lamination. Furthermore, the presence of the surface morphology caused by the particles enables further removal of the remaining gas (air) between the sheets by the action of advancing rollers and vacuum draw down. This positioning in register is of course just a temporary securement by air pressure and surface contact between the image and receptor sheets prior to thermal lamination.

Sensitizing Dyes

Aminoarylketones have been found to be photobleachable spectral sensitizing dyes which are soluble in developed solutions and therefore removable from photopolymerized compositions. These dyes have been found to be particularly efficient in sensitizing photopolymerization, photodepolymerization, and photosolubilization reactions. The dyes are particularly useful when they are soluble in aqueous alkaline solutions of pH greater than 7.5 since they will tend to be leached out of polymerizable and polymerized compositions by aqueous alkaline developers. This helps prevent any possibility of background staining.

The preferred class of aminoarylketones may be represented by the formulae

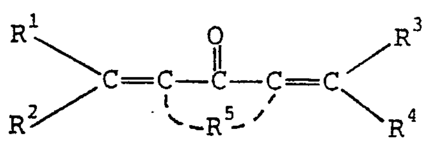

or

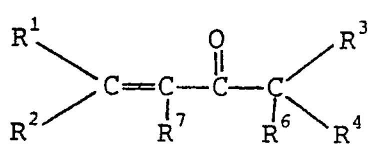

wherein $R^1$, $R^2$, $R^3$, $R^4$, and $R^6$ are independently selected from hydrogen, alkyl (substituted or not substituted), aryl (substituted or not, e.g., phenyl, naphthyl), or 5- or 6-membered heterocyclic (e.g.,

containing only C, N, S, Se, or O ring atoms),
$R^5$ represents the atoms necessary to complete a 5-, 7-, or 6-membered ring comprising only C, N, S, Se, or O ring atoms, with no more than two ring atoms being other than carbon,
further characterized by the fact that at least one of $R^1$ through $R^7$ has a carboxylic acid group (including salts or aqueous hydrolyzable esters in either basic or acid solutions, depending upon the pH of the developer thereof) and at least one of $R^1$, $R^2$, $R^3$, $R^4$, or $R^6$ is an aromatic group having a dialkylamino, diarylamino, or alkylarylamino substituent of up to 20 carbon atoms per alkyl or alkyl group. Preferably any alkyl substituent is a lower alkyl substituent, with each alkyl group having 1 to 4 carbon atoms. Preferably the aromatic (i.e., aryl) group has up to 10 ring carbon atoms and is most preferably phenyl.

Examples of particularly useful groups formed by $R^5$ include 5-, 6-, or 7- membered non-eromatic, carboryclic and hetercoryclic rings, but are not limited to

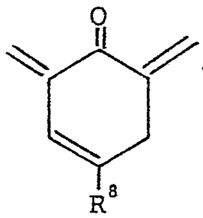 and 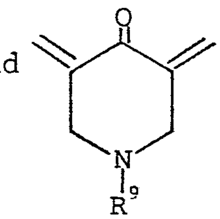 and 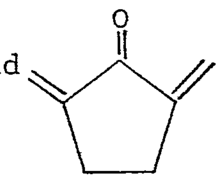 and 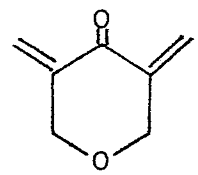

wherein $R^8$ is selected from hydrogen, alkyl, alkoxy, aryl, halogen, etc. and $R^9$ is selected from alkyl (preferably 1 to 4 carbon atoms), carboxy aliphatic (e.g.,

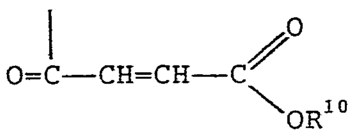

wherein $R^{10}$ is selected from hydrogen, alkyl, and cations). It is also useful and desirable for the required aromatic substituents to include the carboxy function in the form

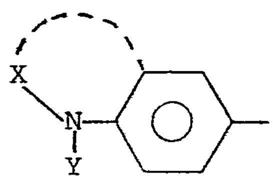

wherein X is either an aliphatic group on the atoms necessary to complete a fused ring structure with the phenyl group and Y is a carboxyl containing moiety. Exemplary structures of dyes of the present invention are

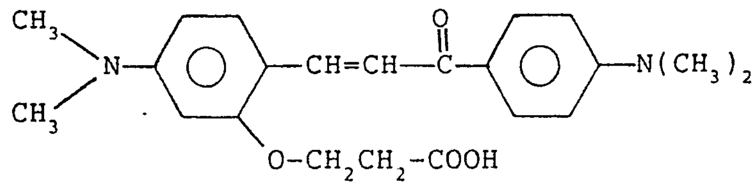

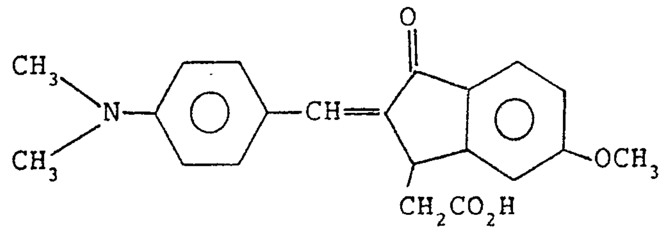

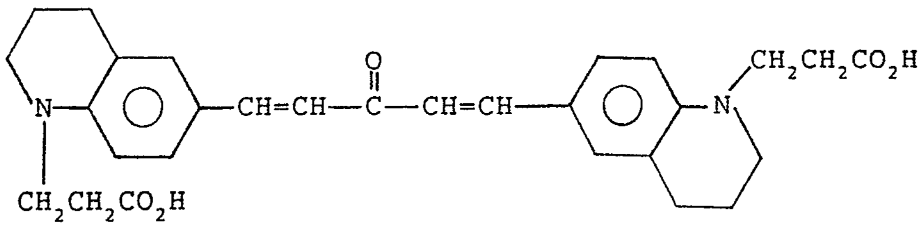

These dye structures show that the required carboxylic acid functionality of the present invention may be variously located within the dye molecule. These particular examples show the carboxylic acid functionality on 1) the aryl group in resonance with the keto group, 2) the bridging moiety $R^5$, and 3) on the dialkylamino group itself. The carboxylic acid functionality may be attached to bridging methylene group (e.g., $R^7$) or on other bridging moieties as shown in Example 5 where the carboxylic acid group is attached to a piperidone bridging group. If arylamino groups are used, the carboxylic acid groups would likewise be substituted on those aryl groups.

The sensitizing dyes of the present invention are believed to be useful in conjunction with all free radical photoacid sensitators including photoinitiators, photodepolymerizers and photosolubilizers. They have been found to be particularly useful with such photoinitiators as the s-triazines and vinylhalomethyl s-triazines (e.g., U.S. Patent 3,954,475 and 3,987,037), onium photoinitiators, particularly iodonium and sulfonium photoinitiators (e.g., U.S. Patents 3,729,313; 3,887,450; 3,895,949; 4,043,819; 4,058,400; 4,058,401 and 4,250,053), and biimidazoles (e.g., biimidazoyls as taught in U.S. 4,162,162).

A particularly useful aspect of the present invention is that the sensitizing dyes of the present invention have a singularly unique capability of being leached from highly crosslinked polymeric systems by the action of aqueous, aqueous alkaline and aqueous alcohol developers in a short period of time. This is highly advantageous because in imaging systems residual or background staining from the sensitizing dye is greatly reduced because so much of the dye is removed from the system. In preferred systems, more than 50% of the dye can be leached from a fully polymerized composition (more than 90% of all available photopolymerizable groups are reacted) by mild sembling for two minutes with at least one solution selected from the group consisting of pure water, aqueous alkaline solutions at pH 9.0 (with NaOH and sufficient snyjactant to enable surface welling of the polymer by the solution), and aqueous alcohol solutions (e.g. 80/20, water/n-propanol). Preferably more than 75% of the dye can be leached out without destruction of the structural integrity of the polymerized mass. Most preferably more than 80% of the sensitizing dye can be thus removed.

When used as a photopolymerizable composition in a color prepress proofing sheet, the composition should of course contain pigments and/or dyes. These colorants (the pigments or dyes) should be present in an amount sufficient to provide a transmission optical density of at least 0.3 measured by transmission at the λ max of the colored or white light in the case of black colorant. The colorants are usually yellow, cyan, magenta or black, with essentially only one color present in the composition. The optical density should be available in a dye coating weight of less than 210mg/ft$^2$ (25 mg/m$^2$).

These and other aspects of the invention will be shown in the following non-limiting examples.

Example 1

The following coating solution was made by mixing:

25 gms pentaerythritrol tetraacrylate

15 gms oligomer described in Preparation II of U.S. 4,304,923

15 gms polyketone resin (Lawter 1717B) believed to be the polymerization product of cyclohexanone and formaldehyde

6.75 gms $OIPF_6$ (diphenyliodonium hexafluorophosphate)

2.20 gms [($Me_2N$ O C=C$)_2$ C=O], (p-dimethylaminobenzyl acetone)

200 gms a 5% Regal 300 Carbon (Cabot) black dispersion made by ball milling the carbon black in a glass jar with glass marbles in 112 trichloroethane solvent. This dispersion also contained 1% Formvar 1595E (Monsanto) as a dispersing aid.

800 gms 112 Trichloroethane

This solution was coated on a polyester substrate having a subbing layer comprised of a polyurea resin to provide a black photopolymer layer having an optical density of 0.70 as measured by white light transmission. The coating was dried in an oven for 1 minute at 70°C. The dry coating was overeacted with a polyvinyl alcohol topcoat at a coating weight of 70mgs/$ft^2$ by using a water solution of 5% Monsanto Gelvatol 20-30. The solution also contained 0.5% by weight Rohm & Haas X-200 wetting agent.

The above coated film was contact exposed with a photographic negative, then developed with a 1.5% sodium hydroxide solution and air dried.

A thermal adhesive coated paper was prepared by coating a 10 percent solution of Goodyear PE222 polyester resin dissolved in methylethylketone (hereinafter MEK) onto 3M Matchprint Commercial Negative proofing paper. The coating weight was 1.0 gms/$ft^2$ after the MEK had evaporated.

The developed film was placed image side in contact with the thermal adhesive on the paper and laminated using the heated rolls of a 3M Model 447 Proofing Laminator. The roll set temperatures were 240°F for the top roll and 150°F for the bottom roll. The laminating speed was 20 inches/minute.

Results: When the laminate had cooled, the polyester film was peeled from the paper leaving the black image embedded in the thermoplastic.

A second image film was prepared and laminated in register to the previously imaged paper.

This created one image of double thickness on the paper. No black image remained on the peeled films. These results demonstrate that the materials of this invention are capable of complete transfer during lamination whether the image is bonded to thermal adhesive or to the previous color. This is the requirement in order to make a color proof since it is necessary to produce both primary and secondary colors.

Example 2

The process of Example 1 was repeated. However, prior to lamination the films were placed in contact with an inverted fluorescent light fixture having two 40 watt, 48 inch lamps (#F40CW) for 20 hours. This exposure stimulated an extended post exposure that may be encountered if the films were first used as an overlay prior to making a single sheet proof.

Results: The laminations were complete as seen as in Example 1 with no image remaining on the polyester film subbings.

Example 3

The samples were made, post exposed as in Example 2 and laminated with and without post exposure.

The difference in this example was that the Lawter 1717B polyketone resin was left out of the coating formulation.

Results: The post exposed would not adhere to a previous color. Thus the production of secondary colors would not be possible. Transfer was complete in the absence of post exposure.

Example 4

In this example 15 gms of the polyketone resin (1717B) in 85 gms of 112 trichloroethane was reacted with 2 gms of isocyanotoethylmethacrylate at 80°C for 6 hours in the presence of 0.2 gms of dibutyltin dilaurate catalyst. This resulted in methacrylate functional polyketone resin. This was used in place of the unreacted 1717B of the Example 1 formulation.

The post exposure-lamination test of Example 3 was performed on this composition.

Results: The results of Example 3 were obtained, (i.e., post exposed images would not laminate). This example demonstrates that the polyketone resin cannot provide hot melt adhesive properties if it is reactive with the monomers and oligomers of the construction.

Example 5

In this example a Union Carbide resin ZKRA-252, which is believed to be substantially the polymerization product of vinyl benzyl ketone, was used in place of the polyketone resin of Example 1.

Results: The results of Example 2 were obtained, (i.e., post exposed images laminated as well as those not post exposed).

Example 6

In this example Dupont Elvacite #2008, which is a low molecular weight methyl methacrylate polymer, was used in place of the 1717B of Example 1. The #2008 was unsatisfactory from the standpoint of proper development since some resin and pigment remained in the nonlight struck areas. However, the lamination properties were satisfactory.

Example 7

In this example the resins of the previous examples were tested to determine qualitatively their tendency to become part of a polymerization network.

Solutions were made of:

2 mgs pentaerythritrol tetraacrylate
2 mgs resin
.3 gms diphenyliodonium hexaphorophosphate
.1 gms p-dimethylaminobenzyl acetone
50 gms 1,1,2-trichloroethane

These solutions were allowed to dry in a 4 inch diameter evaporating dish, then exposed to room light for one week.

The polymerized product was then extracted with 1,1,2-trichloroethane. The soluble portion was dried and weighed. The results are listed below.

| Resin | Soluble Portion |
|---|---|
| None | 0.2 grams |
| Example 1 1717B | 2.1 grams |
| Example 4 reacted 1717B | .4 grams |
| Example 5 ZKRA | 2.0 grams |
| Example 6 Elvacite 2008 | 1.8 grams |

These results indicate that satisfactory laminating properties are obtained only when an adhesive resin is present which does not react to become part of the photopolymerized network.

Example 8

In this example 4 gms of 1717B was used in the formulation of Example 1.

Results: Post exposed samples did not laminate completely, with substantial color remaining on the film in the form of somewhat random deposits.

This example demonstrates that at least 10% by weight of the resin-monomer-oligomer must be non-reactive resin.

Example 9

In this example, 15 grams of a low molecular weight polyester resin (Goodyear PE200) was used in place of the polyketone of Example 1. Good adhesion during transfer was achieved, but as with the poly(methylmethacrylate) resin (Elvacite ®) of the previous example, residual polymer tended to remain in the unexposed areas after development. These materials are therefore functional adhesive resins, but are significantly less preferred. Only the polyketones consistently performed at the highest level in all respects.

Example 10

The following coating solution was made by mixing:

25 gms pentaerythritrol tetraacrylate
15 gms oligomer described in Preparation II of U.S. 4,304,923
15 gms polyketone resin (Lawter 1717B) believed to be the polymerization product of cyclohexanone and formaldehyde
6.75 gms $OIPF_6$ (diphenyliodonium hexafluorophosphate)
2.20 gms $[(Me_2N\ O\ C{=}C)_2\ C{=}O]$, (p-dimethylaminobenzyl acetone)
200 gms a 5% Regal 300 Carbon (Cabot) black dispersion made by ball milling the carbon black in a glass jar with glass marbles in 112 trichloroethane solvent. This dispersion also contained 1% Formvar 1595E (Monsanto) as a dispersing aid.
800 gms 112 Trichloroethane

This solution was coated on a polyester substrate having a subbing layer comprised of a polyurea resin to provide a black photopolymer layer having an optical density of 0.70 as measured by white light transmission. The coating was dried in an over for 1 minute at 70° C. The dry coating way overeacted with a polyvinyl alcohol topcoat at a coating weight of 70mgs/ft$^2$ by using a water solution of 5% Monsanto Gelvatol 20-30. The

solution also contained 0.5% by weight Rohm & Haas X-200 wetting agent.

The above coated film was contact exposed with a photographic negative, then developed with a 1.5% sodium hydroxide solution and air dried.

A thermal adhesive coated paper was prepared by coating a 10 percent solution of Goodyear PE222 polyester resin dissolved in methylethylketone (hereinafter MEK) onto 3M Matchprint Commercial Negative proofing paper. The coating weight was 1.0 gms/ft$^2$ after the MEK had evaporated.

The developed film was placed image side in contact with the thermal adhesive on the paper and laminated using the heated rolls of a 3M Model 447 Proofing Laminator. The roll set temperatures were 240°F for the top roll and 150°F for the bottom roll. The laminating speed was 20 inches/minute.

Results: When the laminate had cooled, the polyester film was peeled from the paper leaving the black image embedded in the thermoplastic. Some bubbles and blisters were noted in the image.

A second imageable film was prepared as above except that the coating solution contained 0.25% by volume of silica particles provided as an approximately 5 micron silica dispersion (5% by weight Siloid® 74, 1% polyvinylformal dispersing aid, in 1,1,2-trichloroethane). This second film was identically exposed, developed and laminated as was the first sample without particulates. No bubbles or blisters appeared in the final image.

A third imageable film with a different pigment and with 0.25% by volume of silica was prepared, exposed and laminated to the second film as was the second film.

This created one image of double thickness on the paper. No black image remained on the peeled films. These results demonstrate that the materials of this invention are capable of complete transfer during lamination whether the image is bonded to thermal adhesive or to the previous color. This is a requirement in order to make a color proof since it is necessary to produce both primary and secondary colors.

Example 11

The second film of Example 10 was made except that the silica particles in the dispersion were replaced by a dispersion of approximately 50 micron polyethylene particles. The solution as coated out with 0.5% by dry volume of the particles in the composition, dried, exposed, and laminated as in Example 1. The results were substantially the same. The size of the particles presented some difficulty in the coating step, but performed well in preventing the formation of blisters and bubbles.

Example 12

The following coating solution was made by mixing:

25 gms pentaerythritrol tetraacrylate

15 gms oligomer described in U.S. 4,304,923 (Preparation II)

15 gms of a polyketone resin (Lawter 1717B)

6.75 gms $0I_2PF_6$ (diphenyliodonium hexafluorophosphate)

2.00 gms (p-dimethylaminobenzyl acetone)

200 gms a 5% Regal 300 Carbon (Cabot) black dispersion made by ball milling the carbon black in a glass jar with glass marbles in 112 trichloroethane solvent. This dispersion also contained 1% poly(vinyl formal) as a dispersing aid.

800 gms 112 trichloroethane

This solution was coated on a polyester film subbed with a polyurea resin to provide a black photopolymer layer having an optical density of 0.70 as measured by white light transmission. The coating was dried in an oven for 1 minute at 70°C. The dry coating was overcoated with a polyvinyl alcohol topcoat at a coating weight of 70 mgs/ft$^2$ by using a water solution of 5% Monsanto Gelvatol 20-30. The solution also contained 0.5% by weight Rohm & Haas X-200 wetting agent.

The above coated film was contact exposed with a photographic negative, then developed with a 1.5% sodium hydroxide solution containing 0.2% by weight Rohm & Haas Triton X-100 wetting agent, rinsed with water and air dried.

A thermal adhesive coated paper was prepared by coating a 10 percent by weight solution of low molecular weight polyester resin dissolved in MEK onto 3M Matchprint Commercial Negative proofing paper. The dried coating weight was 1.0 gms/ft$^2$ after the MEK had evaporated.

The developed film was placed with its image side in contact with the thermal adhesive on the paper and laminated using the heated rolls of a 3M Model 447 proofing laminator. The roll set temperatures were 240°F for the top roll and 150° for the bottom roll. The laminating speed was 20 inches/minute.

When the laminate had cooled, the polyester film was peeled from the paper, leaving the black image embedded in the thermoplastic.

Additional coating solutions were made in yellow, magenta and cyan

Using as pigments in place of the carbon black

CI pigment yellow 14 (CI #21095) (Sun)

CI pigment red 23 (CI #12355) (Heubach)

Sun pigment blue 248 0061 (Sun Chemical Co.)

Coated film of black, cyan, magenta and yellow were prepared as above.

Using a set of lithographic separation negatives, a complete set of black, cyan, magenta and yellow images were exposed in a contact frame (Berkey-Ascor 30x40), developed, and laminated in register to form a four

color proof.

Result: The proof was found to be contaminated with dye stain. Post exposure of the proof for 10 minutes in the contact frame did not produce a white background or unstained colors.

Conclusion: The sensitizing dye of this example (p-dimethylaminobenzyl acetone) is a member of the aminoketone class of sensitizing dyes described in U.S. 3,729,313. Its performance is satisfactory except for a yellow brown dye stain.

Example 13

The experiment of Example 12 was repeated except that the films were postexposed prior to lamination. Although the color of the paper was less yellow-brown than the previous example, the stain was still objectionable.

Example 14

The text of Example 12 was performed using acridine orange in place of the aminoketone dye of Example 12. Unsatisfactory dye stain was again obtained.
Photobleaching still did not completely remove the stain.

Example 15

Preparation of 3,5-bis[N-(2-carboxyethyl)-1,2,3,4-tetrahydro-6-quinolylidene] 1-acetal-4-piperidone.

I. To 133 g (1.0 mole) of 1,2,3,4-tetrahydroquinoline was added 86 g (1.0 mole) methyl acrylate in a stirred reaction flask. 10 g of acetic acid was added and the mixture heated to reflux for 18 hours. The resulting liquid was distilled through a Vigeraux column. Product distilled at 140-150°C, 0.5 mm Hg. Yield = 192 g (87.5%).

II. 463 g (6.3 moles) of dry DMF was stirred in a 3-neck reaction vessel, kept under a nitrogen atmosphere, and then cooled with an ice bath to 5°C. 268 g (1.75 mole) phosphorous oxychloride were dropwise added, keeping the temperature below 20°C. Stirring was continued for 1 hour after completing the addition. 384 g (1.75 mole) of n-(2-carboxy(-)ethyl)-1,2,3,4-tetrahydroquinoline (from first step) was added dropwise to the cooled reaction mixture, keeping the temperature below 30°C. Upon completion of the addition, the reaction mixture was carefully heated to 100°C, and held there for 1 1/2 hours.

The solution was cooled to room temperature and the reaction mixture poured over 2 liters of ice water while stirring well with a mechanical stirrer. Sodium bicarbonate was added slowly with good agitation until the pH was neutral. The reaction mixture was extracted with 3 x 1 liter chloroform, and the combined organics washed with 1 liter of a saturated solution of sodium bicarbonate, then twice with 1 liter of water. The organics were dried with magnesium sulfate, the mixture filtered and concentrated using a rotary evaporator. The remaining DMF was stripped using a vacuum pump. Yield was of a very dark, thick oil, 360 g (83%).

III. 200 g (0.8 mole) of n-(1-carboxyethyl)-1,2,3,4-tetrahydroquinoline-6-carboxaldehyde (from second step) was mixed with 57.5 g (0.4 mole) of 1-acetyl-4-piperidone and 2.5 liters acetic acid. This stirred mixture was cooled to 5°C and 127 ml (2.4 mole) concentrated sulfuric acid was added dropwise. The stirred reaction mixture was allowed to warm to room temperature and stirred for 3 days.

This reaction mixture was poured over a combination of 2 liters ice in 6 liters water while stirring well. A 50% solution of NaOH was carefully added while maintaining the temperature below 40°C with external cooling. When the pH reached 6-7, the liquid portion of the mixture was decanted off. To the remaining gum was added two liters of ethyl acetate. This was heated to reflux and scratched, cooled, and the solid filtered onto a Buchner. To this solid was added 2 liters acetone, and the mixture heated to reflux with good mixing and scratching, then cooled. The solid was filtered onto a Buchner, and oven dried. Yield = 85 g (36%) of a dark solid. $\lambda max(CHCH_3)$ = 464 nm

This dye was used in the formulation of Example 12 to provide a four color proof. In the formulation, 4.0 gms of this dye were used in place of the 2.0 gms of the aminoketone of Example 12 to maximize photographic speed.

Results: No dye stain was seen in the proof. Post exposure was unnecessary. This demonstrates the excellent results of the dyes of this invention.

Example 16

The dye

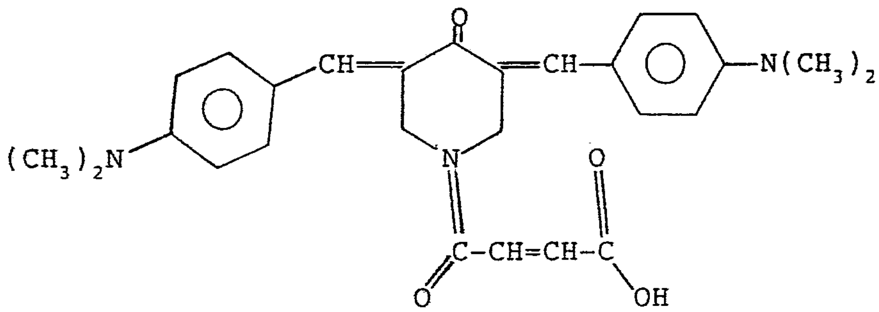

was prepared using the common base catalyzed condensation technique using p-dimethyl amino benzaldehyde and 4-piperidone hydrochloride.

A flask was charged with the following:
100 gms NaOH
100 gms piperidone HCl
250 gms dimethylaminobenzaldehyde
2 litres ab. ethanol
The NaOH was dissolved in the EtOH prior to addition of the components. The flask was heated with good mixing at 65° for six hours. The resulting dye was filtered with a 24 cm Buchner and washed several times with EtOH. This dye was dried in a forced air oven overnight at 30°C to remove the remaining EtOH.

The dry intermediate was then reacted with maleic anhydride.
100 gms dye
1 liter dry tolune (AR grade)
100 gms maleic anhydride

This mixture was heated at 85°C for three hours during which a thioxotropic slurry formed.

The dye was then filtered with the Buchner and dispersed in two liters of water. The slurry was stirred for one hour at room temperature and the pH adjusted to 4.0-4.5. The dye was filtered for the last time and dried overnight at 30°C. $\lambda max = 460$ nm

The dye of this example was used in the formulation of Example 12 where 30 gms of dye replaced the 20 gms of the dye of the first example to maximize photographic speed.

Results: Some dye remained in the imaged and developed films, but this minor amount was easily bleached with light. Thus a proof with a white background and uncontaminated colors could be made.

Example 17

The dye

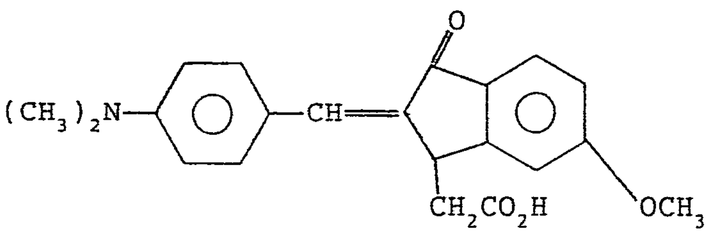

$\lambda max = 416nm(CHCH3)$

was made using the appropriate reagents in a modification of the procedure of Example 16. In the formulations of Example 12, this dye did not stain and thus no postexposure bleaching was necessary.

**Claims**

1. A photopolymerizable composition capable of being imagewise transferred after photopolymerization and development comprising:
1) a polyfunctional photopolymerizable monomer,
2) a polyfunctional photopolymerizable polymer,
3) an inert, thermoplastic polymeric binder, and
4) a photoinitiator system for said monomer and polymer,
said polymeric binder being non-reactive with the polymerization mechanism of said monomer and polymer, the polymeric binder being not soluble in at least one solution selected from the class consisting of aqueous alkaline solutions at a pH of 9.0, aqueous alcohol solutions, and organic solutions, and said

17. A photopolymerizable composition capable of being imagewise transferred after photopolymerization and development comprising:
1) a polyfunctional photopolymerizable monomer,
2) a polyfunctional photopolymerizable polymer,
3) an inert, thermoplastic polymeric binder,
4) a photoinitiator system for said monomer and polymer,
5) 0.025 to 2.5% by volume of color neutral particles, and
6) 2 to 50% by weight of a colorant,
said polymeric binder being non-reactive with the polymerization mechanism of said monomer and polymer, the polymeric binder being not soluble in at least one solution selected from the class consisting of aqueous alkaline solutions at a pH of 9.0, aqueous alcohol solutions, and organic solutions, and said polymeric binder in bulk form having a glass transition temperature or softening point between 38° C and 205° C and a viscosity of $10^3$ poise or less between 63° C and 205° C.

polymeric binder in bulk form having a glass transition temperature or softening point between 38° C and 205° C and a viscosity of $10^3$ poise or less between 63° C and 205° C.

2. The composition of claim 1 wherein both said monomer and polymer have ethylenically unsaturated groups selected from the class consisting of acryloyl and methacryloyl groups.

3. The composition of claim 2 wherein said monomer comprises 10-60% by weight of said composition, said polymer comprises 10-60% by weight of said composition, said polymeric binder comprises from 10-60% by weight of said composition and said photoinitiator system comprises from 0.1 to 20% by weight of said composition.

4. The composition of claim 3 having sufficient amount of a colorant therein to provide a transmission optical density to light of at least 0.3 at a dried coating weight of 25 $mg/m^2$.

5. The composition of claims 1-4 wherein said polymeric binder comprises a polyketone resin.

6. A color prepress proofing element capable of being imagewise laminated to a surface after exposure and development comprising a support having on at least one surface thereof a strippable layer comprising the composition of claim 1.

7. A color prepress proofing element capable of being imagewise laminated to a surface after exposure and development comprising a support having on at least one surface thereof a strippable layer comprising the composition of claim 5.

8. The composition of claim 1 wherein said photoinitiator system comprises a tertiary amino aryl ketone dye having at least one carboxylic acid group thereon and a free radical photoinitiator selected from the group consisting of photoacid generating free radical photoinitiator and a biimidazole.

9. The composition of claim 8 wherein said photoinitiator is selected from the group consisting of photosensitive iodonium salts, photosensitive sulfonium salts, s-triazines, vinylhalomethyl s-triazines, and biimidazoles.

10. The composition of claims 8 and 9 wherein said dye has the formula:

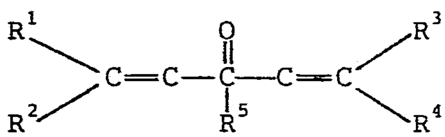

or

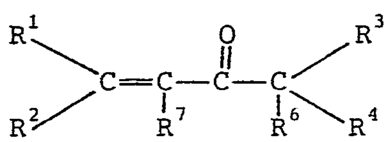

wherein $R^1$, $R^2$, $R^3$, $R^4$ and $R^6$ are independently selected from the group consisting of hydrogen, alkyl, aryl, and 5- or 6-membered heterocyclic rings containing on C, N, S, Se, or O ring atoms,
$R^5$ represents the atoms necessary to complete a 5-, 6-, 7-membered heterocyclic ring having only C, N, S, Se, and O atoms therein, with no more than 2 ring atoms being other than C, and,
at least of $R^1$, $R^2$, $R^3$, $R^4$, $R^5$, and $R^6$ and $R^7$ has a carboxylic and group thereon and at least one of $R^1$, $R^2$, $R^3$, $R^4$ and $R^6$ is an aromatic group having a dialkylamino, diarylamino, or alkylaryl amino substituent.

11. A process for forming a colored image comprising exposing a photosensitive element to an imagewise distribution of actinic radiation, treating said exposed element so as to form a colored image, and adhering said colored image to a receptor sheet by adhesive means, the surface of said photosensitive element which is adhered to said receptor sheet having a photosensitive layer thereon which contains from 0.025 and 10% by volume of particles therein which are at least 1.5 times the thickness of said photosensitive layer.

12. The process of claim 1 wherein said particles are at least 2.0 times the thickness of said photosensitive layer and comprise from 0.05 to 2.5% by volume of said photosensitive layer.

13. The process of claim 12 wherein treating said exposed element to form a colored image comprises developing said exposed element with a liquid developer to remove portions of the photosensitive layer so as to form an image.

14. The process of claim 11 wherein said photosensitive element comprises at least two layers, a photosensitive colorant containing layer and a carrier sheet, and after adhesively securing the image to said receptor sheet, removing said carrier sheet from the image, leaving the image secured to said receptor sheet.

15. A photosensitive prepress color proofing element comprising at least two layers, a substrate and a photosensitive layer, the surface of the element away from said substrate containing particles therein the average diameter of which are at least 1.5 times the thickness of the layer containing the particles.

16. The element of claim 15 wherein the average diameter of the particles is from 2 to 40 times the thickness of the layer containing the particles.